# FASCICULE DE BREVET EUROPEEN

(11) **EP 2 577 766 B1**
(45) Date de publication et mention de la délivrance du brevet: **19.11.2014**
(21) Numéro de dépôt: 11728310.1
(22) Date de dépôt: 24.05.2011
(51) Int. Cl.: H01L 51/52, H01L 51/44

(54) **DISPOSITIF OPTOELECTRONIQUE AVEC ELECTRODE ENTERREE**
OPTOELEKTRONISCHE VORRICHTUNG MIT EINGEBETTETER ELEKTRODE
OPTOELECTRONIC DEVICE HAVING AN EMBEDDED ELECTRODE

(30) Priorité: 28.05.2010 FR 1002271
(43) Date de publication de la demande: 10.04.2013
(73) Titulaire: COMMISSARIAT A L'ENERGIE ATOMIQUE ET AUX ENERGIES ALTERNATIVES, 75015 Paris (FR)
(72) Inventeur: LAURENT, Jean-Yves, F-38420 Domène (FR); VERILHAC, Jean-Marie, F-38000 Grenoble (FR)
(74) Mandataire: Talbot, Alexandre
(86) Numéro de dépôt international: PCT/FR2011/000311
(87) Numéro de publication internationale: WO 2011/148064

(56) Documents cités:
- WO-A1-2011/103952
- DE-A1-102007 046 444
- SIMON G. J. MATHIJSSEN ET AL: "Manipulating the Local Light Emission in Organic Light-Emitting Diodes by using Patterned Self-Assembled Monolayers", ADVANCED MATERIALS, vol. 20, no. 14, 17 juillet 2008 (2008-07-17), pages 2703-2706, XP55005506, ISSN: 0935-9648, DOI: 10.1002/adma.200800299

## Description

### Domaine technique de l'invention

L'invention est relative à un dispositif optoélectronique de type diode utilisant un matériau semi-conducteur.

### État de la technique

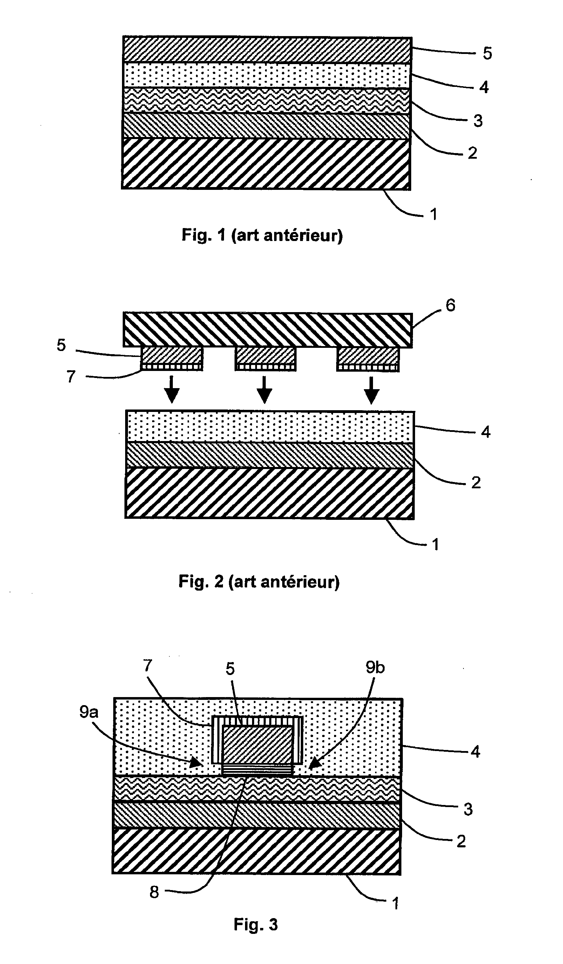

La figure 1 représente schématiquement une architecture classique de diode électroluminescente organique (« Organic Light Emitting Diode » en anglais, OLED). Cette diode comprend un empilement de couches minces sur un substrat transparent 1 en verre. L'empilement comprend généralement une première électrode 2 (anode), une couche 3 d'injection et de transport des trous, une couche 4 en matériau semi-conducteur organique et une seconde électrode 5 (cathode).

Ainsi, dans cette configuration dite verticale, les électrodes 2 et 5 sont placées de part et d'autre de la couche 4, qui mesure environ 150 nm d'épaisseur.

L'électrode 2, du côté du substrat, est généralement en oxyde d'indium et d'étain (« Indium Tin Oxide » en anglais, ITO). L'ITO est à la fois conducteur des trous et transparent au rayonnement émis depuis la couche organique 4. La couche 3, appelée couche d'injection, également transparente à la longueur d'onde d'émission, favorise l'injection des trous de l'anode vers le matériau organique et bloque les électrons. Elle est classiquement formée d'un polymère conducteur, le triarylamine ou le PEDOT-PSS (poly(3,4-éthylènedioxythiophène)-poly(styrène sulfonate) de sodium). Le matériau de la couche 4 est un polymère semi-conducteur comme le poly(para-phenylene vinylene) (PPV).

Les performances optoélectroniques d'une OLED dépendent en particulier de l'injection des porteurs dans la couche organique 4. L'injection des électrons, depuis la cathode 5 vers la couche 4, est facilitée en choisissant un matériau d'électrode ayant un travail de sortie qui coïncide avec l'orbitale de plus basse énergie non occupée (« Lower Unoccupied Molecular Orbital » en anglais, LUMO) du matériau organique.

Les matériaux utilisés en tant que cathode et répondant à ce critère sont le calcium (Ca), le baryum (Ba), le césium (Cs), l'aluminium (Al) et le fluorure de lithium (LiF). Cependant, ces matériaux sont facilement oxydables et présentent une grande instabilité vis-à-vis de l'oxygène et/ou de l'eau.

Ces matériaux, difficiles à mettre en oeuvre, tendent à être remplacés par des métaux moins sensibles à l'oxygène (Au, Pd, Pt, Cu, Ag...). En revanche, ces métaux ont un travail de sortie en décalage avec le niveau d'énergie LUMO.

Le travail de sortie de ces métaux est alors ajusté avec le niveau LUMO du matériau organique par l'intermédiaire d'une monocouche auto-assemblée (« Self-assembled monolayer » en anglais, SAM). Les monocouches auto-assemblées, par exemple de type molécule thiolée, permettent d'augmenter ou de diminuer le travail de sortie des électrodes de quelques dixièmes d'électronvolt à plusieurs électron-volts. On cherche donc à disposer la couche SAM entre la couche organique 4 et l'électrode 5, ce qui pose un certain nombre de problèmes.

Côté anode, la discordance entre les matériaux existe aussi. Dans ce cas, la SAM sera choisie pour adapter le travail de sortie de l'anode au niveau HOMO (« Highest Occupied Molecular Orbital ») du matériau organique.

La réalisation d'une diode verticale comprend classiquement le dépôt de l'électrode 2 sur le substrat 1, le dépôt de la couche active organique 4 et le dépôt de l'électrode 5 sur la couche 4.

On entend par matériaux organiques, les matériaux totalement organiques ou les matériaux composites à base de matériaux inorganiques et de matériaux organiques, par exemple, sous forme de particules.

L'électrode 5 est déposée sur la couche 4 par des techniques d'évaporation sous vide. La technique utilisée est un procédé d'évaporation par effet Joule lent et peu énergétique, compatible avec la couche organique 4.

L'électrode 5 est généralement localisée sur la couche 4 à l'aide d'un masque à travers lequel on réalise le dépôt de métal selon la technique du pochoir.

L'intégration d'une couche SAM dans un empilement de diode comme celui représenté à la figure 1 est difficile. En effet, la couche SAM devant être greffée sur le matériau de l'électrode, elle ne peut pas être déposée sur le matériau organique avant le dépôt du métal de l'électrode.

La figure 2 représente une technique pour l'intégration de la couche SAM. Elle consiste à déposer l'électrode 5 sur un support additionnel 6 en polydiméthylsiloxane (PDMS), puis greffer la couche SAM 7 sur l'électrode 5. Le support 6 est ensuite laminé sur le substrat 1 qui comprend l'électrode 2 et le matériau organique 4. Cette opération de laminage est délicate à mettre en oeuvre et le contact entre l'électrode 5 recouverte de SAM 7 et la couche organique 4 est imparfait, entraînant des problèmes d'injection électrique. En effet, l'adhérence entre les deux couches co-laminées est difficile à garantir sans perturber les propriétés électriques du dispositif.

La publication "Manipulating the Local Light Emission in Organic Light-Emitting Diodes by using Patterned Self-Assembled Monolayers" (Mathijssen, Adv. Mater., Volume 20, Pages 2703 to 2706) se rapporte à des diodes électroluminescentes organiques comprenant une monocouche auto-assemblée en contact avec l'anode.

### Résumé de l'invention

L'invention vise un dispositif optoélectronique performant et facile à réaliser.

Selon l'invention, on tend vers cet objectif par le fait que le dispositif défini par la revendication 1 comprend une première électrode disposée sur un substrat, une seconde électrode comprenant une première face en regard de la première électrode, et une couche en matériau semi-conducteur en contact électrique avec les première et seconde électrodes. La seconde électrode comporte une paroi latérale, adjacente à la première face, recouverte de la couche en matériau semi-conducteur par interposition d'une monocouche auto-assemblée.

L'interface entre le substrat et la première électrode définit un premier plan parallèle et différent d'un deuxième plan défini par la première face de la seconde électrode.

Afin de réduire les courants de fuite du dispositif, on prévoit de recouvrir la première face d'une couche électriquement isolante.

On prévoit, en outre, un procédé de réalisation d'un dispositif optoélectronique facile à mettre en oeuvre et permettant une intégration fiable d'une monocouche auto-assemblée au niveau de l'électrode supérieure.

Le procédé défini par la revendication 9 comprend successivement les étapes de formation d'une première électrode sur un substrat, la formation d'une couche de séparation, la formation d'une seconde électrode sur la couche de séparation, de manière que la seconde électrode présente une paroi latérale en retrait par rapport à un bord du dispositif, le dépôt une monocouche auto-assemblée sur la paroi latérale de la seconde électrode et le dépôt d'un matériau semi-conducteur en contact avec la première électrode et la monocouche auto-assemblée.

Afin de ne pas dégrader le matériau semi-conducteur lors de la formation de l'électrode supérieure, on dépose un matériau électriquement isolant lors de la formation de la couche de séparation.

### Description sommaire des dessins

D'autres avantages et caractéristiques ressortiront plus clairement de la description qui va suivre de modes particuliers de réalisation donnés à titre d'exemples non limitatifs et illustrés à l'aide des dessins annexés, dans lesquels :
- la figure 1 représente une vue en coupe d'une diode électroluminescente organique (OLED) selon l'art antérieur,
- la figure 2 représente une étape de réalisation d'une couche SAM dans une OLED selon l'art antérieur,
- la figure 3 représente une vue en coupe d'un mode de réalisation de dispositif optoélectronique à électrode enterrée selon l'invention,
- les figures 4 et 5 représentent des variantes de réalisation du dispositif de la figure 3,
- la figure 6 représente, en vue de coupe schématique, un dispositif optoélectronique ayant une électrode supérieure sous forme de grille,
- la figure 7 représente, en vue de dessus schématique, le dispositif optoélectronique de la figure 6,
- la figure 8 représente, de manière schématique, un mode de réalisation d'un dispositif optoélectronique à effet tridimensionnel selon l'invention, et
- la figure 9 représente, de manière schématique, trois formes d'électrode enterrée selon l'invention.

### Description d'un mode de réalisation préféré de l'invention

La figure 3 représente un mode de réalisation d'un dispositif optoélectronique à électrode enterrée.

Le dispositif comprend une première électrode 2 disposée sur un substrat 1. La première électrode est, de préférence, munie d'une couche 3 d'injection et de transport des charges.

Le dispositif comprend également une seconde électrode 5 disposée en regard de la première électrode. Cette électrode 5 est de forme ramassée et localisée au centre du dispositif. L'électrode 5 est située au-dessus de l'électrode 2 et du substrat 1 et isolée de l'électrode 2 par une zone de séparation 8.

Une couche 4 en matériau semi-conducteur organique est disposée en contact électrique avec l'électrode 2, par l'intermédiaire de la couche d'injection 3 par exemple.

Comme on l'a précédemment évoqué, étant donné la nature de l'électrode 5, il convient d'établir le contact entre l'électrode 5 et le matériau organique 4 par interposition d'une couche SAM 7. Cette couche 7 ne pouvant pas, pour des raisons de fiabilité, être disposée sur la face inférieure de l'électrode 5, on la dispose sur les autres faces de l'électrode 5 puis on enrobe l'électrode 5 avec le matériau organique 4.

Ainsi, l'électrode 5 comprend une première face parallèle à l'électrode 2 en contact avec la zone de séparation 8 et au moins une seconde face, adjacente à la première face, est recouverte d'une monocouche auto-assemblée (SAM) 7 et du matériau 4.

Dans ce mode de réalisation, la zone de séparation est formée d'une couche 8 de nature électriquement isolante afin d'éviter un court-circuit entre les électrodes 2 et 5. La couche 8 est, de préférence, aux dimensions latérales de l'électrode 5.

Comme cela est représenté sur la figure 3, l'électrode 5 est, de préférence, noyée dans le matériau organique 4. Ses faces latérales et supérieure sont entièrement recouvertes par la monocouche 7 et le matériau 4. Les faces latérales sont sensiblement perpendiculaires à la première face de l'électrode 5.

Le dispositif de la figure 3 peut être employé en tant que dispositif d'émission de lumière ou en tant que dispositif de réception de lumière. Le dispositif est, par exemple, une diode électroluminescente organique (OLED), une cellule solaire ou un photodétecteur organique.

Dans le cas d'une OLED, l'injection des porteurs de charge dans la couche organique 4 s'effectue essentiellement au niveau des faces latérales de l'électrode 5, par l'intermédiaire de la couche SAM 7. Le taux de recombinaison des électrons et des trous est le plus élevé dans des zones 9a et 9b de la couche organique 4 situées à proximité des électrodes 2 et 5.

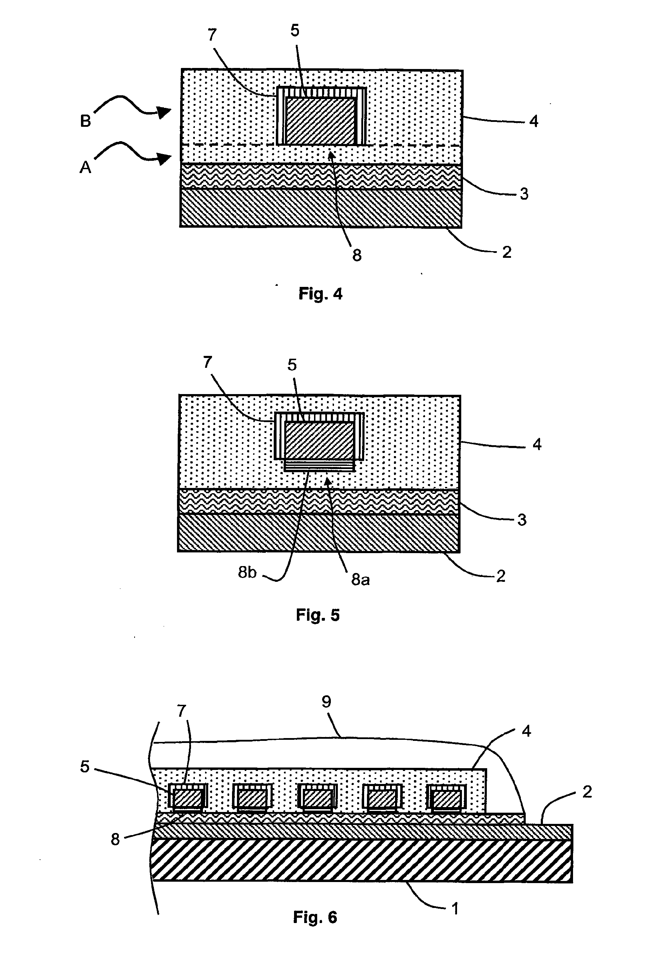

La figure 4 représente une variante de réalisation dans laquelle la zone de séparation 8 est formée par le matériau organique 4 lui-même. L'électrode 5 est alors enrobée par le matériau organique 4 à la manière d'une électrode enterrée. Les faces latérales et supérieure de l'électrode 5, recouvertes de SAM, réalisent un meilleur contact électrique avec le matériau 4 par rapport à la face inférieure. En effet, grâce à la couche 7, le travail de sortie du matériau de l'électrode est proche du niveau LUMO du matériau organique, ce qui diminue la résistance de contact. Les porteurs de charge sont alors injectés préférentiellement au travers des faces recouvertes de SAM.

Dans un autre mode de réalisation, la couche 4 peut être composée d'au moins deux sous-couches en matériaux semi-conducteurs différents, notés A et B sur la figure 4. Par exemple, dans le cas des diodes à polymères (Polymer Light-Emitting Diodes, PLED), le matériau semi-conducteur A peut jouer le rôle de couche bloquante des électrons (ou des trous si l'électrode supérieure est l'anode), afin d'augmenter le rendement du dispositif.

Dans le cas d'un photodétecteur, le matériau semi-conducteur A en contact avec la couche 3 pourra être un matériau accepteur d'électrons (type p) et le matériau semi-conducteur B en contact avec la couche 7 pourra être un matériau donneur d'électrons (type n) (ou inversement selon la nature des électrodes). Cette configuration rendra possible l'illumination du photodétecteur par le haut et non pas par le substrat, ce qui est difficile à réaliser habituellement. Cette structure de la couche 4 peut être utilisée en combinaison avec les différents modes de réalisation du dispositif optoélectronique.

La couche 4 peut aussi être composée d'un mélange d'un semi-conducteur de type p et d'un semi-conducteur de type n pour former une hétérojonction volumique. On peut, par exemple, mélanger un matériau polymère de type p avec des nanoparticules d'un matériau inorganique de type n, tel que le ZnO.

La figure 5 représente une vue en coupe d'un mode de réalisation préféré d'un dispositif optoélectronique. La zone de séparation comprend deux couches 8a et 8b superposées. La couche 8a, formée par le matériau organique 4, est en contact avec la couche 3 et la couche 8b, électriquement isolante, est en contact avec l'électrode 5. Comme dans le cas de la figure 2, le courant est injecté uniquement par l'intermédiaire de la couche SAM 7.

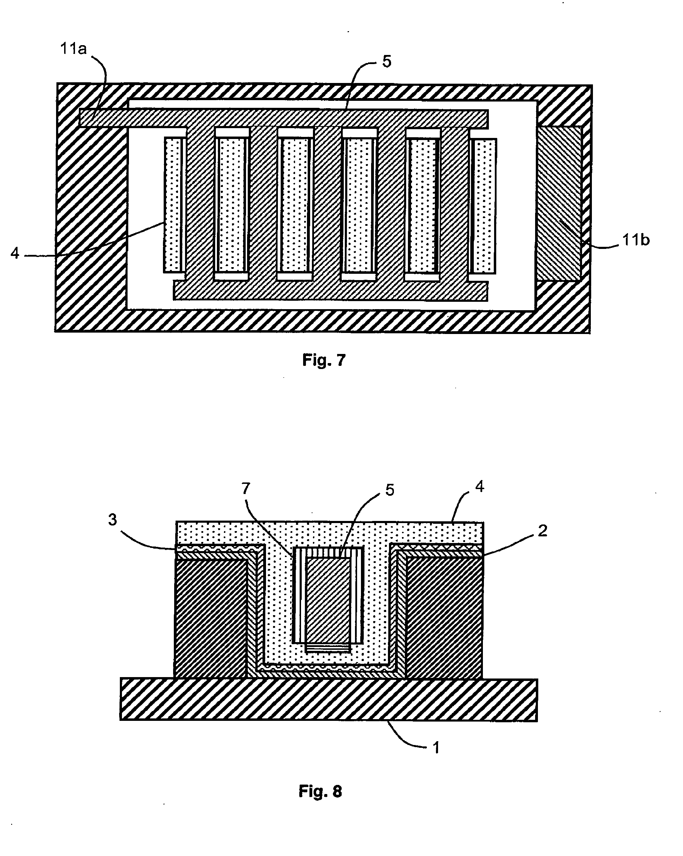

Les figures 6 et 7 représentent en coupe, respectivement en vue de face et en vue de dessus, un exemple de réalisation d'un composant optoélectronique. L'électrode supérieure 5 a la forme d'une grille. La grille 5 comprend des pistes métalliques disposées, de préférence parallèlement et à intervalles réguliers, au-dessus de l'électrode 2.

Cette grille a pour but d'uniformiser le transport des électrons dans la couche organique 4, ce qui augmente la puissance lumineuse de l'OLED.

Sur la figure 6, on remarque que chaque piste est isolée électriquement de l'électrode 2 par la couche de séparation 8 et est recouverte de la couche SAM 7. La couche organique 4 recouvre l'ensemble des pistes métalliques et occupe l'espace compris entre deux pistes successives. Une couche d'encapsulation 9 enveloppe entièrement le matériau organique 4 et protège celui-ci de l'environnement, en particulier de l'air et l'humidité.

Sur la figure 7, le dispositif comprend une zone de contact 11a de l'électrode 5 et une zone de contact 11b de l'électrode 2 assurant la connexion électrique du dispositif avec un circuit externe.

La figure 8 représente un mode de réalisation particulier d'un dispositif optoélectronique à effet tridimensionnel. Contrairement à la configuration planaire des figures 3 à 7, l'électrode 2 se présente sous la forme d'une cuvette. L'électrode 5 recouverte de SAM est placée à l'intérieur de la cuvette formée par l'électrode 2 et remplie de matériau organique 4. Ainsi, les faces latérales de l'électrode 5 sont en regard des flancs de la cuvette 2 tandis que la face inférieure de l'électrode 5 est en regard du fond de la cuvette. Avec cette configuration, la couche organique 4 participe davantage à la génération de photons ce qui augmente l'efficacité de l'OLED.

Un procédé de réalisation du dispositif optoélectronique de la figure 3 est décrit ci-dessous.

Dans une première étape, l'électrode 2 est formée sur le substrat 1. L'électrode 2 est, de préférence, une anode réalisée par un dépôt physique en phase vapeur (PVD) d'ITO (Indium Tin Oxide) sur l'ensemble du substrat. L'électrode 2 est ensuite structurée sur le substrat 1, par exemple par photolithographie.

Le substrat 1, transparent au rayonnement émis par l'OLED, est par exemple en verre ou en plastique pour rendre le dispositif flexible.

L'électrode 2 peut être recouverte d'une couche 3 d'injection et de transport des charges afin d'améliorer la conduction électrique. La couche 3 est, par exemple, en PEDOT : PSS dans le cas d'injection de trous, en ZnO ou TiO2 dans le cas d'injection d'électrons ou sous forme d'une couche SAM adaptée à la fonction de l'électrode. La couche 3 est, de préférence, formée par un dépôt à la tournette. Elle est ensuite séchée, à 150 °C pendant 10 minutes par exemple.

L'étape suivante consiste à former la couche de séparation 8 des électrodes sur la couche 3. La formation de la couche 8 comprend, par exemple, le dépôt sous forme d'îlots ou sous forme de grille d'une couche électriquement isolante (Figures 3 et 6). Cette couche 8 est, de préférence, déposée par impression jet d'encre.

Selon une alternative, la formation de la couche 8 peut comprendre le dépôt d'une couche en matériau semi-conducteur, seule (Figure 4) ou préalablement au dépôt de la couche isolante (Figure 5). Ce dépôt pleine plaque est, de préférence, réalisé à la tournette.

Puis, l'électrode 5 est formée sur la couche de séparation 8. Cette étape peut être réalisée par un dépôt PVD au travers d'un masque pochoir. L'électrode 5 présente au moins une face latérale éloignée d'un bord du dispositif. L'électrode 5 est, par exemple, en or, argent, palladium, nickel ou cuivre et a une épaisseur comprise entre 10 nm et 100 µm.

La couche SAM 7 est ensuite déposée sur les faces libres de l'électrode 5 (latérales et supérieure). La couche SAM est, de préférence, déposée sur toute la surface libre de l'électrode par immersion du substrat dans une solution de 4-methoxybenzenethiol dans l'éthanol par exemple, pour une cathode en or. D'autres types de SAM peuvent être employés selon la nature du matériau d'électrode, par exemple le decanethhiol ou le 4-méthylbenzenethiol pour la cathode, ou des SAM de type pentafluorobenzenthiol ou perfluorodecanethiol pour l'anode.

Dans une variante de réalisation, la couche isolante 8 peut être déposée sur l'ensemble du substrat. Puis, l'électrode 5 et la SAM 7 sont réalisées. Au cours de ces étapes, la couche 8 fait office de couche protectrice des couches inférieures déjà réalisées. Puis, l'ensemble de la couche 8 est supprimé excepté la portion située sous l'électrode 5. L'électrode 5 peut d'ailleurs jouer le rôle de masque lors de cette élimination.

L'étape suivante consiste à déposer la couche en matériau organique 4 sur la surface de l'électrode 5 recouverte de SAM et la face libre de la couche 3. Le matériau organique réalise alors un contact électrique avec l'électrode 2 par l'intermédiaire de la couche 3 et avec l'électrode 5 par l'intermédiaire de la couche SAM 7. Ce dépôt est réalisé sous une atmosphère contrôlée, dans une boîte à gant par exemple.

Le matériau organique 4 peut être à base de petites molécules ou d'oligomères, généralement déposés par évaporation sous vide. Il peut également être constitué d'un polymère semi-conducteur, le poly[p-phénylène vinylène] (PPV) par exemple. La couche de polymère est, de préférence, réalisée par dépôt à la tournette ou par spray sur une épaisseur de 10 nm à 1 µm

Enfin, l'encapsulation de la couche organique est, par exemple, effectuée par collage d'une lame de verre au moyen d'une colle epoxy polymérisable aux ultra-violets. D'autres techniques peuvent être employées mais, étant classiques, elles ne seront pas détaillées dans la présente demande.

Les architectures décrites en relation avec les figures 3 à 8 permettent à la fois une intégration aisée de la couche SAM sur l'électrode supérieure, et un contact intime entre la couche SAM et la couche organique, du fait que le dépôt du matériau organique est réalisé ultérieurement à la formation de l'électrode et de la couche SAM. Le contact électrique et l'injection de courant s'en trouvent grandement améliorés.

Dans les modes de réalisation des figures 3, 5 à 8, la couche électriquement isolante 8 ou 8b permet l'utilisation de techniques de dépôt plus énergétiques que dans l'art antérieur. L'électrode 5 peut être déposée sur cette couche isolante, par un dépôt type PVD par exemple, sans risque de dégradation des couches inférieures. Ainsi, le matériau organique 8a disposé sous la couche isolante 8b est protégé dans l'exemple de la figure 5. Les défauts dans la couche organique à l'origine des courants de fuite et des courts-circuits sont évités.

De plus, l'électrode supérieure peut maintenant être réalisée par le biais d'une photolithographie grâce à cette couche de protection. En effet, la couche isolante 8b protège la couche organique 8a du dépôt et de l'enlèvement de résine servant de masque au dépôt de l'électrode 5. Ainsi, la résolution spatiale de l'électrode supérieure peut être augmentée. Cette électrode peut également être réalisée par ablation laser.

Par ailleurs, le dépôt du matériau organique, généralement sensible à l'air, peut être repoussé en fin de procédé, nécessitant une seule étape sous boîte à gant et non la totalité du procédé. Le procédé de réalisation est ainsi considérablement simplifié.

L'électrode 5 représentée aux figures 3 à 8 est de section rectangulaire. Sur la figure 7, les pistes métalliques formant la grille 5 sont des parallélépipèdes rectangles. Cependant, d'autres formes d'électrode peuvent être envisagées pour augmenter la surface d'injection de l'électrode supérieure et ainsi augmenter le rendement du dispositif.

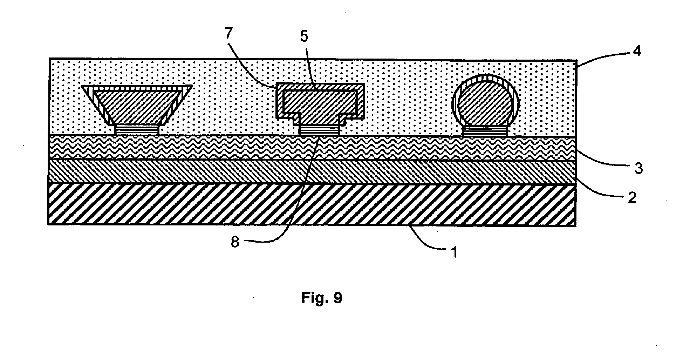

La figure 9 représente plusieurs exemples de forme d'électrode. L'électrode 5 pourra être de section trapézoïdale (à gauche sur la figure), de section polygonale quelconque (au centre) ou encore de section circulaire (à droite sur la figure).

De nombreuses variantes et modifications du dispositif optoélectronique décrit ici apparaîtront à l'homme du métier. Le fonctionnement du dispositif a été décrit en relation avec une OLED. Cependant, l'invention n'est pas limitée à un type particulier de dispositif optoélectronique, organique ou inorganique.

En particulier, le matériau de la couche 4 peut être un semi-conducteur inorganique. En effet, le problème d'injection des porteurs de charge se pose également dans le cas d'un semi-conducteur inorganique. On utilisera alors de la même manière la couche SAM pour rapprocher le travail de sortie du métal de la bande de conduction du matériau semi-conducteur.

De même, le dispositif a été décrit avec une cathode en tant qu'électrode supérieure. On pourra également envisager d'utiliser une anode dont on modulera le travail de sortie pour le rapprocher du niveau d'énergie HOMO du matériau organique (ou de la bande de valence du matériau inorganique) et le dispositif sera alors dit de « structure inverse ». Enfin, les deux électrodes pourront comprendre une monocouche auto-assemblée en contact avec le matériau organique. La couche SAM associée à l'électrode inférieure joue alors le rôle de couche d'injection.

## Revendications

1. Dispositif optoélectronique comprenant:
- une première électrode (2) disposée sur un substrat (1),
- une seconde électrode (5) comprenant une première face en regard de la première électrode;
- une couche en matériau semi-conducteur (4) en contact électrique avec les première et seconde électrodes, l'interface entre le substrat (1) et la première électrode (2) définissant un premier plan parallèle à et différent d'un deuxième plan défini par la première face de la seconde électrode, **caractérisé en ce que** la seconde électrode (5) comporte une paroi latérale, adjacente à la première face, recouverte de la couche en matériau semi-conducteur (4) par interposition d'une monocouche auto-assemblée (7) (SAM).

2. Dispositif selon la revendication 1, **caractérisé en ce que** la première face est recouverte d'une couche électriquement isolante (8, 8b).

3. Dispositif selon la revendication 2, **caractérisé en ce que** la couche électriquement isolante (8) est en contact avec la première électrode (2).

4. Dispositif selon la revendication 2, **caractérisé en ce que** la couche électriquement isolante (8b) est séparée de la première électrode (2) par une couche en matériau semi-conducteur (8a).

5. Dispositif selon la revendication 1, **caractérisé en ce que** la couche en matériau semi-conducteur (4) comprend deux sous-couches (A, B) en des matériaux semi-conducteurs différents.

6. Dispositif selon la revendication 1, **caractérisé en ce que** la seconde électrode (5) comporte une seconde face, opposée à la première face, recouverte de la couche en matériau semi-conducteur (4) par interposition de la monocouche auto-assemblée (7).

7. Dispositif selon la revendication 1, **caractérisé en ce que** la première électrode (2) est munie d'une couche d'injection (3) des charges.

8. Dispositif selon la revendication 1, **caractérisé en ce que** le matériau semi-conducteur (4) est un matériau organique.

9. Procédé de réalisation d'un dispositif optoélectronique comprenant les étapes suivantes :
- prévoir une première électrode (2) disposée sur un substrat (1),
- former une couche de séparation (8),
- former une seconde électrode (5) sur la couche de séparation, de manière que la seconde électrode comprenne une première face en regard de la première électrode et présente une paroi latérale en retrait par rapport à un bord du dispositif,
- déposer une monocouche auto-assemblée (7) sur la paroi latérale de la seconde électrode (5), et
- déposer un matériau semi-conducteur en contact électrique avec la première électrode (2), la deuxième électrode et la monocouche auto-assemblée (7).

10. Procédé selon la revendication 9, **caractérisé en ce que** la monocouche auto-assemblée (7) et le matériau semi-conducteur (4) sont déposés sur l'ensemble de la seconde électrode (5).

11. Procédé selon la revendication 9, **caractérisé en ce que** la formation de la couche de séparation comprend le dépôt d'une couche en matériau semi-conducteur (8a).

12. Procédé selon l'une quelconque des revendications 9 à 11, **caractérisé en ce que** la formation de la couche de séparation comprend le dépôt d'un matériau électriquement isolant (8, 8b).

## Patentansprüche

1. Optoelektronische Vorrichtung, umfassend:
- eine erste Elektrode (2), die auf einem Substrat (1) angeordnet ist,
- eine zweite Elektrode (5), die eine erste Seite gegenüber der ersten Elektrode umfasst,
eine Schicht aus Halbleitermaterial (4) in elektrischem Kontakt mit der ersten und der zweiten Elektrode, wobei die Grenzfläche zwischen dem Substrat (1) und der ersten Elektrode (2) eine erste Ebene definiert, die zu einer durch die erste Seite der zweiten Elektrode definierten zweiten Ebene parallel und hiervon verschieden ist, **dadurch gekennzeichnet, dass** die zweite Elektrode (5) eine an die erste Seite angrenzende Seitenwand umfasst, die durch Einzügen einer selbstorganisierenden Monoschicht (7) (SAM) mit der Halbleitermaterialschicht (4) bedeckt ist.

2. Vorrichtung nach Anspruch 1, **dadurch gekennzeichnet, dass** die erste Seite mit einer elektrisch isolierenden Schicht (8, 8b) überzogen ist.

3. Vorrichtung nach Anspruch 2, **dadurch gekennzeichnet, dass** die elektrisch isolierende Schicht (8) mit der ersten Elektrode (2) in Kontakt ist.

4. Vorrichtung nach Anspruch 2, **dadurch gekennzeichnet, dass** die elektrisch isolierende Schicht (8b) durch eine Halbleitermaterialschicht (8a) von der ersten Elektrode (2) getrennt ist.

5. Vorrichtung nach Anspruch 1, **dadurch gekennzeichnet, dass** die Halbleitermaterialschicht (4) zwei Unterschichten (A, B) aus unterschiedlichen Halbleitermaterialien umfasst.

6. Vorrichtung nach Anspruch 1, **dadurch gekennzeichnet, dass** die zweite Elektrode (5) eine von der ersten Seite abgewandte zweite Seite aufweist, die durch Einfügen der selbstorganisierenden Monoschicht (7) mit der Halbleitermaterialschicht (4) bedeckt ist.

7. Vorrichtung nach Anspruch 1, **dadurch gekennzeichnet, dass** die erste Elektrode (2) mit einer Schicht zur Injektion (3) der Ladungen versehen ist.

8. Vorrichtung nach Anspruch 1, **dadurch gekennzeichnet, dass** das Halbleitermaterial (4) ein organisches Material ist.

9. Verfahren zur Herstellung einer optoelektronischen Vorrichtung, umfassend die folgenden Schritte:
- Vorsehen einer ersten Elektrode (2), die auf einem Substrat (1) angeordnet ist,
- Ausbilden einer Trennschicht (8),
- Ausbilden einer zweiten Elektrode (5) auf der Trennschicht, so dass die zweite Elektrode eine erste Seite gegenüber der ersten Elektrode umfasst und eine gegenüber einem Rand der Vorrichtung zurückspringende Seitenwand aufweist,
- Abscheiden einer selbstarganisierenden Monoschicht (7) auf der Seitenwand der zweiten Elektrode (5) und
- Abscheiden eines Halbleitermaterials in elektrischem Kontakt mit der ersten Elektrode (2), der zweiten Elektrode und der selbstorganisierenden Monoschicht (7).

10. Verfahren nach Anspruch 9, **dadurch gekennzeichnet, dass** die selbstorganisierende Monoschicht (7) und das Halbleitermaterial (4) auf der gesamten zweiten Elektrode (5) abgeschieden werden.

11. Verfahren nach Anspruch 9, **dadurch gekennzeichnet, dass** die Ausbildung der Trennschicht das Abscheiden einer Halbleitermaterialschicht (8a) umfasst.

12. Verfahren nach einem der Ansprüche 9 bis 11, **dadurch gekennzeichnet, dass** die Ausbildung der Trennschicht das Abscheiden eines elektrisch isolierenden Materials (8, 8b) umfasst.

## Claims

1. Optoelectronic device comprising:
- a first electrode (2) arranged on a substrate (1),
- a second electrode (5) comprising a first surface facing the first electrode (2),
- a layer of a semiconductor material (4) in electric contact with the first and second electrodes, the interface between the substrate (1) and the first electrode (2) defining a first plane parallel and different from a second plane defined by the first surface of the second electrode, **characterized in that** the second electrode (5) comprises a side wall, adjacent to the first surface, covered with the semiconductor material layer (4) by the insertion of a self-assembled monolayer (7) (SAM).

2. The device according to claim 1, **characterized in that** the first surface is covered with an electrically insulating layer (8, 8b).

3. The device according to claim 2, **characterized in that** the electrically insulating layer (8) is in contact with the first electrode (2).

4. The device according to claim 2, **characterized in that** the electrically insulating layer (8b) is separated from the first electrode (2) by a semiconductor material layer (8a).

5. The device according to claim 1, **characterized in that** the semiconductor material layer (4) comprises two sub-layers (A, B) made from different semiconductor materials.

6. The device according to claim 1, **characterized in that** the second electrode (5) comprises a second surface, opposite to the first surface, covered with the semiconductor material layer (4) by the insertion of the self-assembled monolayer (7).

7. The device according to claim 1, **characterized in that** the first electrode (2) is provided with a charge injection layer (3).

8. The device according to claim 1, **characterized in that** the semiconductor material layer (4) is an organic material.

9. A method for producing an optoelectronic device comprising the steps of:
- providing a first electrode (2) arranged on a substrate (1),
- forming a separation layer (8),
- forming a second electrode (5) on the separation layer, so that the second electrode (5) comprises a first surface facing the first electrode (2) and has a side wall which is offset from an edge of the device,
- depositing a self-assembled monolayer (7) on the side wall of the second electrode (5), and
- depositing a semiconductor material in electrical contact with the first electrode (2), the second electrode (5) and the self-assembled monolayer (7).

10. The method according to claim 9, **characterized in that** the self-assembled monolayer (7) and the semiconductor material (4) are deposited over the entire second electrode (5).

11. The method according to claim 9, **characterized in that** the formation of the separation layer comprises the deposition of a semiconductor material layer (8a).

12. The method according to any of claims 9 to 11, **characterized in that** the formation of the separation layer comprises the deposition of an electrically insulating material (8, 8b).
